# EUROPÄISCHE PATENTANMELDUNG

(11) **EP 2 107 642 A2**
(43) Veröffentlichungstag der Anmeldung: **07.10.2009**
(21) Anmeldenummer: 09004942.0
(22) Anmeldetag: 03.04.2009
(51) Int. Cl.: H01R 4/06

(54) **Verbindungsanordnung und Verfahren zur Kontaktierung von leitfähigen textilen Halbzeugen**

(30) Priorität: 04.04.2008 DE 202008004637 U; 09.05.2008 DE 102008023137
(71) Anmelder: Amphenol-Tuchel Electronics GmbH, 74080 Heilbronn (DE)
(72) Erfinder: Schewe, Eckhard, 74074 Heilbronn (DE); Ellsäßer, Uwe, 74321 Bietigheim-Bissingen (DE)

(57) **Zusammenfassung**

Die Erfindung betrifft eine Verbindungsanordnung umfassend mindestens ein erstes flexibles und leitfähiges Halbzeug, wobei das leitfähige textile Halbzeug über gewellt angeordnete paarweise beabstandete Leitfäden in dem textilen Halbzeug verfügt, sowie mindestens ein Durchdringanpresselement zur Verbindung des ersten flexiblen leitfähigen Halbzeuges mit einem zweiten textilen leitfähigen Halbzeug oder einer Leiterplatte, wobei mindestens ein Durchdringanpresselement als mechanisches und gleichzeitig auch elektrisches Verbindungselement vorgesehen ist, zum mechanischen und elektrischen Verbinden der Leitfäden des ersten flexiblen und leitfähigen textilen Halbzeuges mit dem zweiten textilen leitfähigen Halbzeug oder der Leiterplatte.

## Beschreibung

Die Erfindung bezieht sich auf eine Verbindungsanordnung und ein Verfahren zur Kontaktierung von leitfähigen textilen Halbzeugen und zum Verbinden mit einem solchen Halbzeug untereinander oder mit einer Leiterplattenanordnung. Die Erfindung bezieht sich daher insbesondere auf die Kontaktierung zweier leitfähiger textilen Halbzeugen miteinander und/oder auf die Kontaktierung eines leitfähigen textilen Halbzeuges mit einer daran angeschlossenen Leiterplattenanordnung.

Leitfähiges textiles Halbzeug besteht im allgemeinen aus horizontalen in Längsrichtung verlaufenden und vertikalen in Querrichtung verlaufenden nicht leitfähigen Textilen und dehnbaren Fäden, zwischen denen elektrisch leitfähige (Leitfäden oder auch Drähte genannt) angeordnet sind, die im allgemeinen in horizontaler Richtung zwischen den textilen Fäden verlaufen und so angeordnet sind, dass das textile Halbzeug in Längs- und Querrichtung dehnbar bleibt.

Als leitfähige textile Halbzeuge werden im Folgenden insbesondere Leiterbandanordnungen aus textilen Halbzeugen bezeichnet. Ein solches Leiterband ausgebildet aus leitfähigem textilem Halbzeug der vorgenannten Art, umfasst eine flache Bauart, ähnlich einer Flachbandleitung, die allerdings aus gewebtem Textil ausgebildet ist und vorgesagte elektrisch leitfähige Fäden (Leitfäden) enthält. Durch die Struktur des textilen Halbzeugs sind die Abstände zwischen den leitenden Fäden nicht eindeutig definiert. Dem Grunde nach verlaufen jedoch eine Vielzahl von im Wesentlichen entweder gewellt angeordneten Paarweise beabstandeten Leitfäden in dem textilen Halbzeug. Die Anordnung und die Anzahl der Leitfäden kann entsprechend des Anwendungsfalles und der notwendigen Stromtragfähigkeit eines solchen textilen Halbzeuges angepasst werden.

Es ist bereits bekannt, die leitfähigen Fäden an einem Ende des textilen Halbzeuges manuell offen zu legen, um an den Enden der freigelegten leitfähigen Fäden ein Anschlusselement anzulöten.

Dieses Verfahren ist Jedoch aufwendig und führt nicht zu einer präzisen Ausrichtung mit den Leiterbahnen, die üblicherweise auf einem Anschlusselement vorgesehen sind. Soll ein solches leitfähiges textiles Leitungsband mit einem zweiten leitfähigen textilen Leitungsband verbunden werden oder aber das manuell freigelegte Ende auf einer Leiterplatte elektrisch verbunden werden, so führt vorgenannte Verbindungstechnik insbesondere das Anlöten zu Schwierigkeiten und Problemen. Einerseits ist die undefinierte Lage der leitfähigen Fäden eine Ursache für unpräzises Löten und andererseits bestehen nach dem Lötprozess Probleme mit der Haltbarkeit der elektrischen Verbindung. Es ist bei solchen Verbindungen bekannt, dass entweder die elektrische Leitfähigkeit mehrerer vergleichbarer Verbindungsanordnungen völlig unterschiedlich ausgestaltet sind. Es besteht also im Fertigungsprozess eine Nichtkonstanz gewünschter elektrischer Kennwerte, die es zu überwinden gilt. Weiterhin ist in der praktischen Handhabung einer solchen Verbindungsanordnung bekannt, dass sich teilweise die leitfähigen Fäden lösen oder an der Lötstelle brechen, so dass die Verbindung entweder teilweise oder komplett versagt und eine elektrische Übertragung nicht mehr stattfinden kann.

Es sei ferner auf die DE 101 61 527 A1 hingewiesen, an der eine Aufbau- und Verbindungstechnik für textile Strukturen beschrieben ist. Bei einer Ausführungsform dieser Technik wird textiles Material, in das eine Vielzahl elektrischer Leiter eingewebt ist, verwendet, wobei insbesondere jeder Leiter widerrum aus einer Vielzahl von elektrisch leitfähigen Kettfäden aufgebaut ist. Damit die in Textilmaterial angeordneten Leiter mit Kontaktstellen eines elektronischen Bauelementes, sprich einer Leiterplatte elektrisch verbindbar sind, wird dieses zunächst relativ zu den Leitern positioniert und zwar so, dass die Leiter möglichst unmittelbar an den Kontaktstellen des elektronischen Bauelementes anliegen. Insofern kommt es dort zu einer Anliegekontaktierung. Zu diesem Zweck können zusätzliche Justiereinrichtungen an oder in dem Textilmaterial vorgesehen sein. Nach dem Positionieren an den Kontaktstellen werden die anliegenden Leiter mittels einer Löteinrichtung gepresst und angelötet. Dabei muss der Andruckschritt der Leiter an die Kontaktstellen derart präzise ausgeführt werden, dass die geschmolzenen Isolierungen der elektrisch leitfähigen Kettfäden sowie vorhandenes elektrisch isoliertes Schussmaterial verdrängt wird.

Bei einer anderen Ausführungsform wird ein elektronisches Bauelement nicht unmittelbar an die elektrischen Leiter angeschlossen, sondern beispielsweise über eine flexible Leiterplatte auf der Kupferbahnen angebracht sind.

Dabei können in einem Bereich, in welchem die Leiter über die Leiterbahnen verlaufen, die nicht leitenden Schussfäden vorerst entfernt werden, um dann die elektrisch leitfähigen Kettfäden besser zugänglich zu machen, um so einen besseren elektrischen Kontakt für die Verbindung zu erreichen.

Die vorliegende Erfindung will die zuvor genannten Nachteile im Stand der Technik überwinden und beabsichtigt daher ein Verfahren anzugeben, mit dem leitfähiges textiles Flachbandkabel, vorzugsweise in seiner Längsrichtung als elastisch ausgebildetes Halbzeug, präzise und mit geringem Aufwand kontaktiert werden kann.

Die vorliegende Erfindung soll darüber hinaus ein Verfahren angeben, mit dem auch zwei solcher textilen Halbzeugen miteinander verbunden werden können. Die Kontaktierung soll vorzugsweise an einer beliebigen Anschlussstelle des textilen Halbzeuges möglich sein, so dass verschiedene Anordnungen entlang der längsgestreckten textilen Leitungsbandanordnung möglich ist. Dadurch wird eine unterschiedliche Anzahl von Abgriffen denkbar und gleichzeitig auch möglich, zwei textile Leiterbahnanordnungen an mehreren paarweise beabstandeten Punkten zu verbinden, um damit die Leitfähigkeit und auch die Verbindung selbst sicher zu stellen.

Die Erfindung sieht ferner vor, ein Verbindungselement, insbesondere für leitfähige Halbzeuge, sowie eine Verbindungsanordnung für solche.

Aufgabe der vorliegenden Erfindung ist es auch, die Anzahl der Verfahrensschritte zu reduzieren und das aufwendige Freilegen der elektrischen Fäden vor dem Kontaktieren innerhalb des Textiles zu vermeiden.

Zur Kontaktierung von leitfähigem textilem Halbzeug wird daher erfindungsgemäß vorgeschlagen, das Halbzeug benachbart an einer gewünschten Anschlussstelle entweder einzuspannen und zu straffen oder in entspanntem Zustand direkt mit einem korrespondierenden Halbzeug zu verbinden, derart, dass die Verbindung mittels einer kombinierten Durchdring- und Anpressverbindung hergestellt wird. Vorzugsweise kann hierzu eine Nietverbindung verwendet werden, deren Nietkragen so ausgebildet sind, dass einerseits die Niete als Durchdringelement dient und nach dem Zusammenpressen der Niete die Nietkrägen auch im Auflagebereich des elektrisch textilen Halbzeuges zur elektrischen Anlage kommen.

Es wird vorzugsweise eine feste drehsichere Verbindung erreicht, dadurch, dass die Nietung in ihrer Ausprägung und ihrer Form und Beschaffenheit an die Verbindungsanforderungen angepasst werden kann. Es kann allerdings jede andere geeignete Durchdring- und Anpressverbindung verwendet werden, um eine mechanische und gleichzeitig elektrische Verbindung zu erzielen.

Erfindungsgemäß wird dabei der elektrische Kontakt über die metallische Niete erzeugt, die gleichzeitig durch ihre spezielle Form auch eine mechanische Verbindung darstellt. Alternativ kann eine Durchdringklammerverblndung verwendet werden, die erfindungsgemäß ebenfalls die Funktion einer elektrischen und mechanischen Verbindung in ein und derselben Klammeranordnung vereint. Eine solche Klammer wird im Verfahren durch eine oder mehrere der textilen Halbzeuge hindurch gedrungen und dann mittels eines Umformwerkzeuges in die gewünschte Endform gepresst.

Erfindungsgemäß kann auf die gleiche Art und Weise ein textiles flexibles Leiterband mit einer festen oder flexiblen Leiterplatte verbunden werden. Hierzu werden vorzugsweise an den Kontaktstellen korrespondierend Leiterpads/Kontaktfelder einerseits auf der festen oder flexiblen Leiterplatte vorgesehen und korrespondierend dazu an dem textilen Halbzeug in der Position der auszuwählenden Verbindung. Dadurch liegen sich zwei paarweise zueinander orientierte Kantaktfelder gegenüber, welche vorzugsweise über eine Bohrung oder Öffnung verfügen, durch die eine Durchdring- und Anpressverbindung einführbar ist. Nach dem Endringen der Durchdring- und Anpressverbindung durch das flexible Textilband hindurch, kommt es zur Kontaktierung und Berührung mit einer Vielzahl der elektrischen Leltfäden innerhalb des textilen Halbzeuges beim Durchdringen desselben. Die Durchdring und Anpressverbindung wird vollständig durch die Lelterbahn des textilen Halbzeuges hindurch geführt und verdrängt dabei einige der Leitfäden, so dass es zu einer radialen Anlage mit dem Durchdringanpresselement kommt. Zur Erhöhung der Leitfähigkeit kann partiell an der vorgesehenen Kontaktierstelle das textile Material des textilen Halbzeuges soweit entweder thermisch oder mechanisch entfernt werden, dass eine Vielzahl der Leltfäden zugänglich wird. Diese kann man so depositionieren, dass entweder keine der Leitfäden oder nur eine geringe Anzahl durch die Durchdringanpresselemente oder durch das Durchdringanprosselement beschädigt werden beim Durchdringen durch das textile Halbzeug.

Vorzugsweise und ideal werden alle Leitfäden so depositioniert, dass diese an der Außenkontur des Durchdringanpresselementes zur Anlage kommen.

Der Kragen oder die angebrachte Geometrie am Durchdringanpresselement, welches sich flächig auf dem textilen Halbzeug abstützt, sorgt für einen zusätzlichen mechanischen und elektrischen Halt und Verbindung mit derselben. Auf der Kontaktierseite des flexiblen leitfähigen Halbzeuges lässt sich zusätzlich an der partiell freigelegten Stelle ein elektrisch leitfähiges Pad aufbringen. Diese Pads oder allgemein als Kontaktfeld bezeichnete Elemente werden dann beim anfoigenden Zusammenpressen der Durchdringanpressverbindung in eine flächige Anpresskontaktlage gebracht und erzeugen insofern eine elektrische Verbindung. Die Auswahl der Materialien der Kontaktfelder richtet sich nach dem speziellen Anwendungsfall und kann wahlweise erfolgen. Vorzugsweise wird eine galvanische Beschichtung aufgebracht, die Umwelteinflüssen gerecht wird und möglicherweise beim Einsatz solcher textilen Halbzeugen in technischer Funktionskleidung auch einer Waschbarkeit widersteht.

Weitere Vorteile, Ziele und Einzelheiten der Erfindung ergeben sich aus der Beschreibung von Ausführungsbeisplelen anhand der Zeichnung; die Zeichnung zeigt:
Fig. 1 einen Schnitt durch eine Verbindungsanordnung, umfassend ein leitfähiges textiles Halbzeug, mit einer damit verbundenen Leiterplatte;
Fig. 2 eine Draufsicht auf eine Anordnung gemäß Fig. 1;
Fig. 3 einen detaillierten Längsschnitt nach dem Verpressen des Durchdrlnganpresselementes gemäß Fig. 1;
Fig. 4 einen Schnitt nach dem Verpressen einer alternativen Durchdringanpressverbindung gemäß Fig. 1.

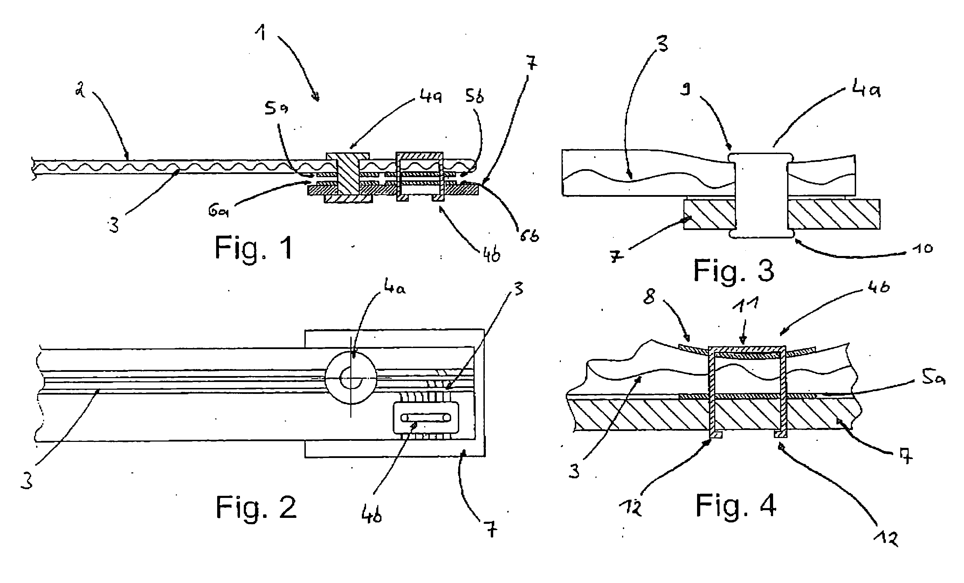

Die Figuren 1, 2, 3 und 4 zeigen eine erfindungsgemäße Verbindungsanordnung von leitfähigen textilen Halbzeugen mit einer Leiterplatte. Die hier dargestellte Leiterplatte ist als feste Leiterplatte ausgebildet, kann alternativ aber auch eine flexible Leiterplatte oder ein textiles leitfähiges Halbzeug darstellen.

In Fig. 1 ist eine Schnittdarstellung einer Verbindungsanordnung 1 offenbart.

Die Verbindungsanordnung 1 umfasst ein im Wesentlichen längserstrecktes, flaches, textiles leitfähiges Halbzeug 2, in welchem eine Vielzahl von Leitfäden 3 angeordnet sind. Das textile leitfähige Halbzeug 2 ist als textiles Flachbandkabel ausgebildet.

In dem textilen leitfähigen Flachbandkabel verlaufen eine Vielzahl von in Wellen angeordneten Leitfäden, die so angebracht sind, dass das Textilband in seiner Längserstreckung flexibel und dehnbar ausgebildet ist. Die Leitfäden 3 sind paarweise beabstandet über das leitfähige Textilband angeordnet und können, wie in Fig. 3 gezeigt, gestreckt und gedehnt werden. Die Dehnungsgrenze eines solchen leitfähigen Textilbandes wird erreicht, wenn die Leitfäden 3 im Wesentlichen gestreckt sind und als linienförmige elektrische Leitlinie durch das flexible Textilband 2 vorlaufen. Bei einer weiteren Dehnung besteht oder bestünde die Gefahr des Abreisens. Insofern können die Leitfäden 3 vorzugsweise, gemäß den Anforderungen der Anwendung so ausgelegt werden, dass die gewählte Wellenanordnung, wie in Fig. 1 gezeigt, die erwartungsgemäße Längenstreckung eines solchen flexiblen Textilbandes erfüllen. Die Verbindungsanordnung 1 umfasst neben dem flexiblen elektrischen Textilband 2 eine PCB-Leiterplatte 7, welche beabstandet zum flexiblen leitfähigen Textilband 2 angeordnet ist. Die Leiterplatte 7 verfügt über ein Kontaktfeid 6a. welches gegenüber einem zweiten Kontaktfeid 5a, welches an dem flexiblen leitfähigen Textilband 2 angeordnet ist. Erfindungsgemäß sind zwei Durchdringanpresselemente 4a, 4b vorgesehen, welche durch das flexible leitfähige Textilband 2 hindurch gedrungen sind und an ihrem wirkseitigem Ende durch die PCB-Leiterplatte 7 hindurchreichen. Vor dem Zusammenpressen des Durchdringanpresselementes 4a, 4b sind die Kontaktfelder 5a, 5b und die weiteren Kontaktfelder 6a, 6b, welche an dem Durchdringanpresselement 4a, 4b angeordnet sind, zueinander beabstandet, so dass ein Schlitz zwischen den Kontaktfeider 5a, 5b und 6a, 6b besteht. Die Durchdringanpresselemente 4a, 4b können wahlweise einzeln oder zusammen verwendet werden. In Fig. 1 ist eine Kombination zu zweier unterschiedlicher Durchdringanpresselemente 4a, 4b gezeigt.

In Fig. 2 sieht man die Aufsicht auf die erfindungsgemäße Verbindungsanordnung 1, gemäß Fig. 1, wobei deutlich wird, dass der Verlauf der Leitfäden 3 im flexiblen leitfähigen Textilband 2 auch nur partiell ausgeführt sein kann, wie hier im oberen Beriech. Im rechten vorderen Bereich verlaufen Abzweigungen der Leiterbahnen 3 quer zu den Durchdringanpresselementen 4b.

In Fig. 3 ist die Verbindungsanordnung 1 nach dem Zusammenpressen des Durchdringanpresselementes 4a dargestellt. Dadurch wird der Schlitz zwischen den Kontaktfeldern 5a, 6a, gemäß Fig. 1 geschlossen, so dass die Kontaktfelder zu einer anpressenden flächigen Anlage kommen. Der Kragen 9a, 10a des Durchdringanpresselementes 4a kommt dabei einerseits zur Anlage mit dem flexiblen leitfähigen Textilband 2 und andererseits mit der Fläche beziehungsweise der Unterseite der PCB-Leiterplatte 7. Weiterhin ist ersichtlich, dass die Dicke des flexiblen leitfähigen Textilbandes 2 dadurch reduziert wird, dass durch die Kompression des Durchdringanpresselementes 4a sich diese reduziert.

In Fig. 4 ist eine ähnliche Anordnung zu sehen. Fig. 4 zeigt, wie in Fig. 1 dargestellte zweite Verbindung mit dem Durchdringanpresselement 4b, welche hier dargestellt ist als Klammer 4b, im Gegensatz zu einer beispielhaft dargestellten Durchdringanpressverbindung beziehungsweise einem Durchdringanpresselement 4a ausgeführt als Niete in Fig. 3. Die Klammer 4b verfügt über einen Steg 11 zur Anlage mit einem weitren Kontaktfeld 8, welches auf der Oberfläche des flexiblen leitfähigen Textilbandes 2 angeordnet ist. Zwischen dem flexiblen leitfähigen Textilband 2 und der PCB-Leiterplatte 7 sind analog der zuvor beschriebenen Anordnung zwischen diesen Kontaktfeldern 5b, 6b angeordnet, die hier im zusammengepressten Zustand als ein sozusagen miteinander verschmolzenes Kontaktfeld dargestellt sind. Bei ausreichend hohem Anpressdruck kommt es zwischen den Kontaktfeldern zu einer Kaltverschweißung, welche die mechanische und elektrische Verbindung weiterhin verbessert. Die Klammer 4b verfügt weiterhin über Halbstege 12 an der Unterseite der PCB-Leiterplatte, Diese halten in einer mechanischen sicheren Position und stellen gleichzeitig Mittel dar, welche ein unbeabsichtigtes Lösen des Durchdringanpresselementes 4a/der Klammer verhindern.

### Bezugszeichenliste

Verbindungsanordnung und Verfahren zur Kontaktierung von leitfähigen textilen Halbzeugen
- 1: Verbindungsanordnung
- 2: flexibles leitfähiges Halbzeug/Textilband
- 3: Leitfäden
- 4a, 4b: Durchdringanpresselement
- 5a, 5b: Kontaktfeld
- 6a, 6b: zweites Kontaktfeld
- 7: PCB-Leiterplatte
- 8: drittes Kontaktfeld
- 9, 10: Kragen
- 11: Steg
- 12: Halbstege

## Patentansprüche

1. Verbindungsanordnung (1) umfassend mindestens ein erstes flexibles und leitfähiges Halbzeug, wobei das leitfähige textile Halbzeug über gewellt angeordnete paarweise beabstandete Leitfäden in dem textilen Halbzeug verfügt, sowie mindestens ein Durchdringanpresselement (4a, 4b) zur Verbindung des ersten flexiblen leitfähigen Halbzeuges mit einem zweiten textilen leitfähigen Halbzeug (2) oder einer Leiterplatte (7), **dadurch gekennzeichnet, dass** mindestens ein Durchdringanpresselement (4a, 4b) als mechanisches und gleichzeitig auch elektrisches Verbindungselement vorgesehen ist, zum mechanischen und elektrischen Verbinden der Leitfäden des ersten flexiblen und leitfähigen textilen Halbzeuges mit dem zweiten textilen leitfähigen Halbzeug (2) oder der Leiterplatte (7).

2. Verbindungsanordnung (1) gemäß Anspruch 1, **dadurch gekennzeichnet, dass** mindestens ein Durchdringanpresselement (4a, 4b) als Niete ausgebildet ist.

3. Verbindungsanordnung (1) gemäß Anspruch 1 oder 2, **dadurch gekennzeichnet, dass** mindestens ein Durchdringanpresselement (4a, 4b) als Klammer ausgebildet ist.

4. Verbindungsanordnung (1) gemäß einem der vorhergehenden Ansprüche, **dadurch gekennzeichnet, dass** elektrische Leitfäden (3) im flexiblen Halbzeug (2) vorgesehen sind, derart, dass das Textil flexibel und dehnbar ist.

5. Verbindungsanordnung (1) gemäß einem der vorhergehenden Ansprüche, **dadurch gekennzeichnet, dass** mindestens ein Kontaktfeld (5a, 5b, 6a, 6b) zwischen dem ersten flexiblen leitfähigen Halbzeug (2) und einer Leiterplatte oder dem zweiten flexiblen leitfähigen Halbzeug (2) elektrisch und mechanisch zur Anlage kommt.

6. Verbindungsanordnung (1) gemäß einem der vorhergehenden Ansprüche, **dadurch gekennzeichnet, dass** mehrere Kontaktfelder (5a, 5b, 6a, 6b) zwischen dem flexiblen leitfähigen Halbzeug (2) und einem weiteren flexiblen leitfähigen Halbzeug (2) oder einer Leiterplatte (7) angeordnet sind.

7. Verbindungsanordnung (1) gemäß Anspruch 4, 5 oder 6, **dadurch gekennzeichnet, dass,** zwischen mindestens zwei Leitfäden (3) und dem Durchdringanpresselement (4a, 4b) eine elektrische Anlage der Leitfäden (3) an einer Außenfläche des Durchdringanpresselementes (4a, 4b) erfolgt.

8. Verfahren zum Herstellen einer Verbindungsanordnung gemäß einem der Ansprüche 1 bis 6 mit folgenden Schritten:
a) Bereitstellen eines flexiblen leitfähigen Halbzeuges (2) mit Im Halbzeug (2) angeordneten Leiterfäden (3),
b) Bereitstellen einer Leiterplatte mit mindestens einem Kontaktfeld (6a, 6b),
c) Positionieren des flexiblen leitfähigen Halbzeuges (2) mit seinen Leitfäden (3) auf dem Kontaktfeld (6a, 6b) der Leiterplatte,
d) Anordnen und Durchdringen des flexiblen leitfähigen Halbzeuges (2) und der Leiterplatte (7) mittels mindestens einem Durchdringanpresselement (4a, 4b) unter Erzeugung einer elektrischen und mechanischen Wirkverbindung.

9. Verfahren gemäß Anspruch 8, **dadurch gekennzeichnet, dass** weiterhin ein Schritt vorgesehen ist, bei dem die zu verbindenden Positionen des flexiblen leitfähigen Halbzeuges (2) mit seinen Leitfäden (3) vor dem Verbinden mechanisch oder thermisch so behandelt wird, dass die Leitfäden (3) offen zugänglich sind.

10. Verfahren gemäß einem der vorhergehenden Ansprüche 8 oder 9, **dadurch gekennzeichnet, dass** das flexible leitfähige Halbzeug (2) ein flexibles Textilband mit elektrischen Leitfäden darstellt.
